# EUROPEAN PATENT APPLICATION

(11) **EP 2 782 138 A2**
(43) Date of publication of application: **24.09.2014**
(21) Application number: 14154293.6
(22) Date of filing: 07.02.2014
(51) Int. Cl.: H01L 29/423, H01L 29/49, H01L 29/66, H01L 29/786, H01L 27/12

(54) **Semiconductor device and method for manufacturing the same**

(30) Priority: 22.03.2013 JP 2013061045
(71) Applicant: Kabushiki Kaisha Toshiba, Tokyo 105-8001 (JP)
(72) Inventor: Nakano, Shintaro, Tokyo 105-8001 (JP); Ueda, Tomomasa, Tokyo 105-8001 (JP); Fujiwara, Ikuo, Tokyo 105-8001 (JP); Yamaguchi, Hajime, Tokyo 105-8001 (JP)
(74) Representative: HOFFMANN EITLE

(57) **Abstract**

According to one embodiment, a semiconductor device (210-213) includes a substrate (150) having an upper surface (150a), a foundation insulating layer (160) provided on the upper surface (150a), and a thin film transistor (110-113). The thin film transistor (110-113)includes a first gate electrode (11), first, second and third insulating layers (21, 22, 23), a semiconductor layer (30), and first and second conductive layers (41, 42). The first gate electrode (11) is provided on a portion of the foundation insulating layer (160). The first insulating layer (21) covers the first gate electrode (11) and the foundation insulating layer (160). The second insulating layer (22) is provided on the first insulating layer (21), and has first, second and third portions (p1, p2, p3). The semiconductor layer (30) contacts the second insulating layer (22) on the third portion (p3), and has fourth, fifth portions and sixth portions (p4, p5, p6). The first conductive layer (41) contacts the fourth portion (p4). The second conductive layer (42) contacts the fifth portion (p5). The third insulating layer (23) covers a portion of the semiconductor layer (30).

## Description

### FIELD

Embodiments described herein relate generally to a semiconductor device and a method for manufacturing the same.

### BACKGROUND

Semiconductor devices that include, for example, imaging elements, arithmetic elements, amplifying elements, memory elements, etc., are formed, for example, on silicon substrates, etc. It is desirable to further increase the integration of such semiconductor devices.

### BRIEF DESCRIPTION OF THE DRAWINGS

FIG. 1 is a schematic cross-sectional view showing a semiconductor device according to a first embodiment;
FIG. 2 is a schematic cross-sectional view showing a portion of the semiconductor device according to the first embodiment;
FIG. 3 is a schematic plan view showing a portion of the semiconductor device according to the first embodiment;
FIG. 4 is a schematic cross-sectional view showing a portion of another semiconductor device according to the first embodiment;
FIG. 5 is a schematic cross-sectional view showing a portion of another semiconductor device according to the first embodiment;
FIG. 6 is a schematic cross-sectional view showing a portion of another semiconductor device according to the first embodiment;
FIG. 7 is a schematic cross-sectional view showing a portion of a semiconductor device according to a second embodiment;
FIG. 8 is a schematic cross-sectional view showing a portion of another semiconductor device according to the second embodiment;
FIG. 9 is a flowchart showing a method for manufacturing a semiconductor device according to a third embodiment;
FIG. 10A to FIG. 10C are schematic cross-sectional views in order of the processes, showing a method for manufacturing the semiconductor device according to the third embodiment;
FIG. 11 is a flowchart showing a method for manufacturing a semiconductor device according to a fourth embodiment; and
FIG. 12A to FIG. 12C are schematic cross-sectional views in order of the processes, showing the method for manufacturing the semiconductor device according to the fourth embodiment.

### DETAILED DESCRIPTION

According to one embodiment, a semiconductor device includes a substrate including a functional element, the substrate having an upper surface, a foundation insulating layer provided on the upper surface, and a thin film transistor. The thin film transistor includes a first gate electrode, a first insulating layer, a second insulating layer, a semiconductor layer, a first conductive layer, a second conductive layer, and a third insulating layer. The first gate electrode is provided on a portion of the foundation insulating layer. The first insulating layer covers the first gate electrode and the foundation insulating layer. The first insulating layer includes silicon and nitrogen. The second insulating layer is provided on the first insulating layer. The second insulating layer includes oxygen and at least one selected from Al, Ti, Ta, Hf, and Zr. The second insulating layer has a first portion, a second portion separated from the first portion in a first direction in a plane parallel to the upper surface, and a third portion positioned on the first gate electrode to be provided between the first portion and the second portion. The semiconductor layer of an oxide including at least one selected from In, Ga, and Zn contacts the second insulating layer on the third portion. The semiconductor layer has a fourth portion, a fifth portion separated from the fourth portion in the first direction, and a sixth portion provided between the fourth portion and the fifth portion. The fourth portion is disposed between the sixth portion and the first portion when projected onto the plane parallel to the upper surface. The fifth portion is disposed between the sixth portion and the second portion when projected onto the plane parallel to the upper surface. The first conductive layer contacts the fourth portion. The second conductive layer contacts the fifth portion. The third insulating layer covers a portion of the semiconductor layer other than the fourth portion and the fifth portion. The third insulating layer includes oxygen and at least one selected from Si, Al, Ti, Ta, Hf, and Zr.

According to one embodiment, a semiconductor device includes a substrate, a foundation insulating layer, a first insulating layer, a second insulating layer, and a thin film transistor. The substrate includes a functional element. The substrate has an upper surface. The foundation insulating layer is provided on the upper surface. The first insulating layer is provided on the foundation insulating layer. The first insulating layer includes silicon and nitrogen. The second insulating layer is provided on the first insulating layer. The second insulating layer includes oxygen and at least one selected from Al, Ti, Ta, Hf, and Zr. The second insulating layer has a first portion, a second portion separated from the first portion in a first direction in a plane parallel to the upper surface, and a third portion provided between the first portion and the second portion. The thin film transistor includes a semiconductor layer, a gate insulation layer, a first gate electrode, a first conductive layer, a second conductive layer, and a third insulating layer. The semiconductor layer of an oxide including at least one selected from indium, gallium, and zinc contacts the second insulating layer on the third portion. The semiconductor layer has a fourth portion, a fifth portion separated from the fourth portion in the first direction, and a sixth portion provided between the fourth portion and the fifth portion. The fourth portion is disposed between the sixth portion and the first portion. The fifth portion is disposed between the sixth portion and the second portion. The gate insulation layer is provided on the sixth portion. The gate insulation layer includes metal and oxygen. The first gate electrode is provided on the gate insulation layer. The first conductive layer contacts the fourth portion. The second conductive layer contacts the fifth portion. The third insulating layer covers a portion of the semiconductor layer other than the fourth portion and the fifth portion. The third insulating layer includes oxygen and at least one selected from Si, Al, Ti, Ta, Hf, and Zr.

According to one embodiment, a method for manufacturing a semiconductor device is disclosed. The method can include forming a foundation insulating layer on an upper surface of a substrate including a functional element, and forming a first gate electrode on a portion of the foundation insulating layer. The method can include forming a first insulating layer including silicon and nitrogen to cover the first gate electrode and the foundation insulating layer, and forming a second insulating layer including oxygen and at least one selected from Al, Ti, Ta, Hf, and Zr on the first insulating layer. The method can include forming a semiconductor film of an oxide including at least one selected from indium, gallium, and zinc on the second insulating layer and forming a semiconductor layer from the semiconductor film by patterning the semiconductor film using the second insulating layer as a stopper, and forming a third insulating layer including oxygen and at least one selected from Si, Al, Ti, Ta, Hf, and Zr on the semiconductor layer and on the second insulating layer. The method can include making a first hole from an upper surface of the third insulating layer to reach the semiconductor layer and making a second hole from the upper surface of the third insulating layer to reach the semiconductor layer and be separated from the first hole. In addition, the method can include forming a thin film transistor including the semiconductor layer by filling a conductive material into the first hole and the second hole.

Various embodiments will be described hereinafter with reference to the accompanying drawings.

The drawings are schematic or conceptual; and the relationships between the thicknesses and widths of portions, the proportions of sizes between portions, etc., are not necessarily the same as the actual values thereof. Further, the dimensions and/or the proportions may be illustrated differently between the drawings, even for identical portions.

In the drawings and the specification of the application, components similar to those described in regard to a drawing thereinabove are marked with like reference numerals, and a detailed description is omitted as appropriate.

### First embodiment

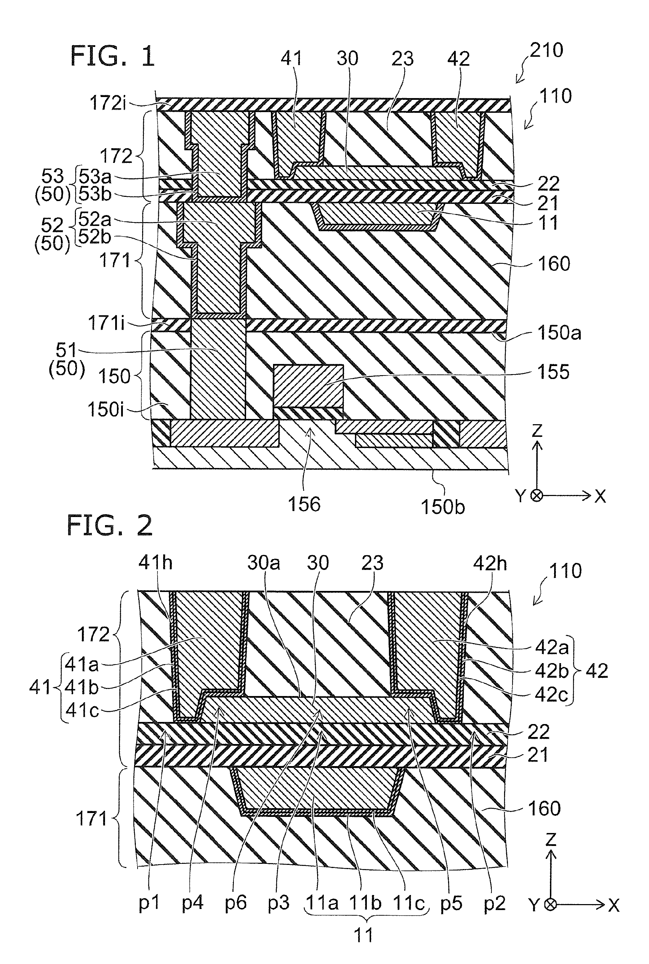

FIG. 1 is a schematic cross-sectional view showing a semiconductor device according to a first embodiment.

As shown in FIG. 1, the semiconductor device 210 according to the embodiment includes a substrate 150, a foundation insulating layer 160, and a thin film transistor 110.

The substrate 150 includes a functional element 155. The substrate 150 may include, for example, a semiconductor substrate such as a silicon substrate, etc. An SOI substrate may be used as the substrate 150. The substrate 150 has an upper surface 150a. The functional element 155 includes, for example, an imaging unit 156 provided at a lower surface 150b of the substrate 150. The substrate 150 further includes an inter-layer insulating layer 150i covering the functional element 155. The upper surface of the inter-layer insulating layer 150i corresponds to the upper surface of the substrate 150.

The foundation insulating layer 160 is provided on the upper surface 150a of the substrate 150.

In the specification of the application, the "state of being provided on" includes not only the state of being disposed directly on but also the state in which another component is inserted therebetween.

In the example, the semiconductor device 210 includes the substrate 150, a first interconnect layer 171 provided on the substrate 150, and a second interconnect layer 172 provided on the first interconnect layer 171. The foundation insulating layer 160 is included in the first interconnect layer 171. In the example, a first inter-layer insulating layer 171i is provided between the substrate 150 and the first interconnect layer 171, that is, between the substrate 150 and the foundation insulating layer 160.

A direction perpendicular to the upper surface 150a of the substrate 150 is taken as a Z-axis direction. One direction perpendicular to the Z-axis direction is taken as an X-axis direction. A direction perpendicular to the Z-axis direction and the X-axis direction is taken as a Y-axis direction.

The thin film transistor 110 is provided inside the first interconnect layer 171 and the second interconnect layer 172. The thin film transistor 110 is provided on the foundation insulating layer 160.

The thin film transistor 110 includes a first gate electrode 11, a first insulating layer 21, a second insulating layer 22, a semiconductor layer 30, a first conductive layer 41, a second conductive layer 42, and a third insulating layer 23.

The first gate electrode 11 is provided on a portion of the foundation insulating layer 160. For example, the lower surface and side surface of the first gate electrode 11 are provided around the foundation insulating layer 160. Other than the upper surface of the first gate electrode 11, the first gate electrode 11 is filled into the foundation insulating layer 160. In other words, the first gate electrode 11 and the foundation insulating layer 160 have a damascene configuration.

The first insulating layer 21 covers the first gate electrode 11 and the foundation insulating layer 160. The first insulating layer 21 includes silicon and nitrogen. In other words, the first insulating layer 21 includes a first compound including silicon and nitrogen. The first insulating layer 21 may include, for example, silicon nitride or silicon oxynitride.

The second insulating layer 22 is provided on the first insulating layer 21. The second insulating layer 22 includes oxygen and at least one selected from Al, Ti, Ta, Hf, and Zr. In other words, the second insulating layer 22 includes a second compound including oxygen and at least one selected from Al, Ti, Ta, Hf, and Zr.

The semiconductor layer 30 is provided on a portion of the second insulating layer 22 to contact a portion of the second insulating layer 22. The semiconductor layer 30 includes an oxide including at least one selected from indium (In), gallium (Ga), and zinc (Zn). The semiconductor layer 30 is a semiconductor layer of an oxide. The semiconductor layer 30 is, for example, amorphous. The semiconductor layer 30 may have a polycrystal portion.

The first conductive layer 41 is provided on a portion of the semiconductor layer 30. The second conductive layer 42 is provided on one other portion of the semiconductor layer 30. The first conductive layer 41 is one selected from a source electrode and a drain electrode. The second conductive layer 42 is the other selected from the source electrode and the drain electrode.

The third insulating layer 23 covers the semiconductor layer 30. The third insulating layer 23 includes oxygen and at least one selected from Si, Al, Ti, Ta, Hf, and Zr. In other words, the third insulating layer 23 includes a third compound including oxygen and at least one selected from Si, Al, Ti, Ta, Hf, and Zr.

In the example, an interconnect 50 is provided. In the example, the interconnect 50 includes a first interconnect 51, a second interconnect 52, and a third interconnect 53. The first interconnect 51, the second interconnect 52, and the third interconnect 53 extend along the Z-axis direction. The first interconnect 51 pierces the inter-layer insulating layer 150i of the substrate 150 along the Z-axis direction. For example, one end of the first interconnect 51 is electrically connected to the functional element 155.

In the specification of the application, the "state of being electrically connected" includes the state in which two conductors are in direct contact, the state in which a current flows in two conductors via another conductor, and the state in which an electric element such as a switching element, etc., inserted between two conductors can form a state in which a current flows.

The second interconnect 52 pierces the foundation insulating layer 160 along the Z-axis direction and is electrically connected to the first interconnect 51.

The third interconnect 53 pierces the first insulating layer 21, the second insulating layer 22, and the third insulating layer 23 along the Z-axis direction and is electrically connected to the second interconnect 52. One end of the third interconnect 53 is electrically connected to, for example, the thin film transistor 110. For example, the one end of the third interconnect 53 may be connected to, for example, at least one selected from the first conductive layer 41 and the second conductive layer 42.

For example, the first interconnect 51 and the second interconnect 52 may be provided without the third interconnect 53 being provided. In such a case, one end of the second interconnect 52 may be connected to the first gate electrode 11 of the thin film transistor 110.

Thus, the interconnect 50 pierces at least the foundation insulating layer 160 along a direction (the Z-axis direction) intersecting the upper surface 150a of the substrate 150. The interconnect 50 is connected to, for example, at least one selected from the first gate electrode 11, the first conductive layer 41, and the second conductive layer 42. For example, the interconnect 50 electrically connects the at least one selected from the first gate electrode 11, the first conductive layer 41, and the second conductive layer 42 to the functional element 155.

For example, the interconnect 50 pierces the first interconnect layer 171 along the Z-axis direction. The interconnect 50 may further pierce the second interconnect layer 172 along the Z-axis direction.

In the example, the first interconnect layer 171 includes the foundation insulating layer 160, the first gate electrode 11, and the second interconnect 52. In the example, the second interconnect layer 172 includes the first insulating layer 21, the second insulating layer 22, the semiconductor layer 30, the first conductive layer 41, the second conductive layer 42, the third insulating layer 23, and the third interconnect 53. An upper layer insulating layer 172i may be further provided on the second interconnect layer 172.

In the example, the second interconnect 52 and the third interconnect 53 have a multilayered structure.

For example, the second interconnect 52 includes an upper layer 52a for the second interconnect 52 and a lower layer 52b for the second interconnect 52 that is stacked with the upper layer 52a. The lower layer 52b is disposed, for example, between the upper layer 52a and the foundation insulating layer 160. The upper layer 52a may include, for example, at least one metal selected from aluminum, copper, tungsten, tantalum, molybdenum, and titanium. The lower layer 52b may include, for example, at least one selected from tantalum, tantalum nitride, and titanium nitride. The lower layer 52b for the second interconnect 52 may include a material that is different from that of the upper layer 52a for the second interconnect 52.

For example, the third interconnect 53 includes an upper layer 53a for the third interconnect 53 and a lower layer 53b for the third interconnect 53 that is stacked with the upper layer 53a. The lower layer 53b is disposed, for example, between the upper layer 53a and the third insulating layer 23. The upper layer 53a may include, for example, at least one metal selected from aluminum, copper, tungsten, tantalum, molybdenum, and titanium. The lower layer 53b may include, for example, at least one selected from tantalum, tantalum nitride, and titanium nitride. The lower layer 53b for the third interconnect 53 may include a material that is different from that of the upper layer 53a for the third interconnect 53.

In the semiconductor device 210 according to the embodiment, the thin film transistor 110 that uses the semiconductor layer 30 of an oxide is provided on the substrate 150 that includes the functional element 155. For example, a peripheral circuit of the functional element 155 that is provided in the substrate 150 may be formed from the thin film transistor 110. The integration of the semiconductor device can be increased because the peripheral circuit is formed on the substrate 150 that includes the functional element 155. According to the embodiment, a practical semiconductor device having high integration can be provided.

The thin film transistor 110 is, for example, a thin film transistor having a bottom-gate structure. In the semiconductor device 210, a portion of the interconnect of the first interconnect layer 171 may be used as the first gate electrode 11 of the thin film transistor 110. An example of the thin film transistor 110 will now be described further.

FIG. 2 is a schematic cross-sectional view showing a portion of the semiconductor device according to the first embodiment.

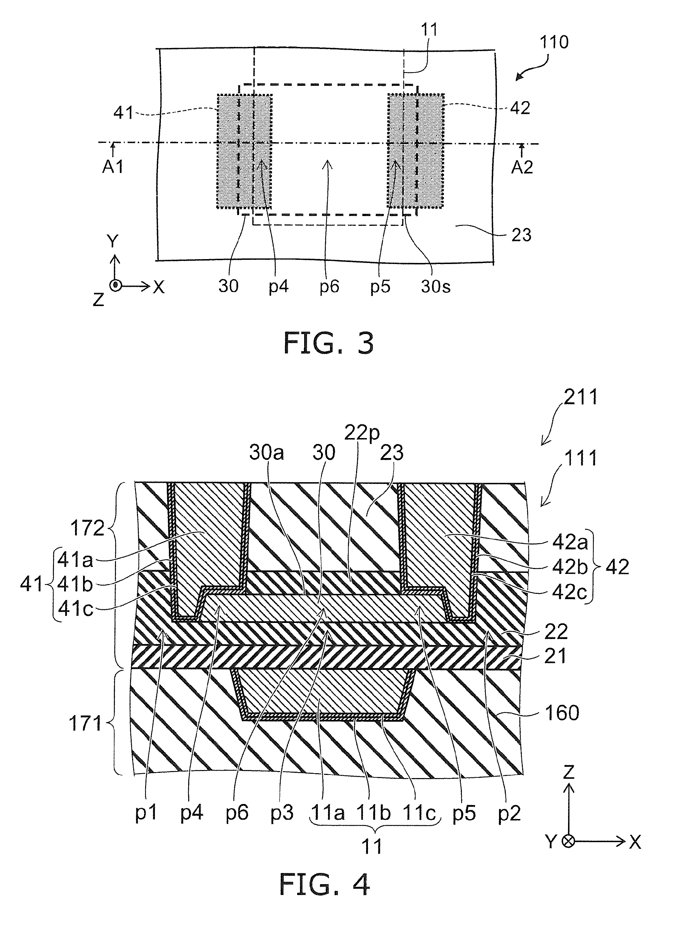

FIG. 3 is a schematic plan view showing a portion of the semiconductor device according to the first embodiment.

FIG. 2 is a cross-sectional view along line A1-A2 of FIG. 3. The thin film transistor 110 included in the semiconductor device according to the embodiment is shown in these drawings.

As shown in FIG. 2 and FIG. 3, the first gate electrode 11 is provided on a portion of the foundation insulating layer 160. The first insulating layer 21 covers the first gate electrode 11 and the foundation insulating layer 160.

The second insulating layer 22 is provided on the first insulating layer 21. The second insulating layer 22 has a first portion p1, a second portion p2, and a third portion p3. The second portion p2 is separated from the first portion p1 in the first direction (in the example, the X-axis direction) in the X-Y plane (the plane parallel to the upper surface 150a of the substrate 150). The third portion p3 is provided between the first portion p1 and the second portion p2. The third portion p3 is positioned on the first gate electrode 11. The third portion p3 opposes the first gate electrode 11 with the first insulating layer 21 interposed.

The semiconductor layer 30 contacts the second insulating layer 22 on the third portion p3. The semiconductor layer 30 has a fourth portion p4, a fifth portion p5, and a sixth portion p6. The fifth portion p5 is separated from the fourth portion p4 in the first direction (the X-axis direction). The sixth portion p6 is provided between the fourth portion p4 and the fifth portion p5.

The fourth portion p4 is disposed between the sixth portion p6 and the first portion p1 when projected onto the X-Y plane. The fifth portion p5 is disposed between the sixth portion p6 and the second portion p2 when projected onto the X-Y plane. The sixth portion p6 overlaps the third portion p3 when projected onto the X-Y plane.

The first conductive layer 41 contacts the fourth portion p4 of the semiconductor layer 30. In the example, the first conductive layer 41 also contacts the first portion p1 of the second insulating layer 22. The second conductive layer 42 contacts the fifth portion p5 of the semiconductor layer 30. In the example, the second conductive layer 42 also contacts the second portion p2 of the second insulating layer 22.

The first conductive layer 41 is formed by, for example, filling a conductive material into a first hole 41h that is provided in the third insulating layer 23. The second conductive layer 42 is formed by, for example, filling a conductive material into a second hole 42h that is provided in the third insulating layer 23. The first hole 41h and the second hole 42h are separated from each other in the X-axis direction.

The third insulating layer 23 covers the portions of the semiconductor layer 30 other than the fourth portion p4 (the portion contacting the first conductive layer 41) and the fifth portion p5 (the portion contacting the second conductive layer 42). For example, the third insulating layer 23 covers an upper surface 30a of the sixth portion p6 of the semiconductor layer 30.

As shown in FIG. 3, the third insulating layer 23 also covers a side surface 30s of the semiconductor layer 30. The side surface 30s is a surface intersecting the X-Y plane.

Thus, in the semiconductor device 210 according to the embodiment, the first insulating layer 21 that includes silicon and nitrogen is provided to cover the foundation insulating layer 160 and the first gate electrode 11 that are included in the first interconnect layer 171. The first insulating layer 21 may include, for example, silicon nitride (i.e., SiNₓ), etc. The first insulating layer 21 functions well as a protective layer.

The second insulating layer 22 contacts the semiconductor layer 30. The second insulating layer 22 may include, for example, aluminum oxide (e.g., Al₂O₃, i.e., AlOₓ), etc. The second insulating layer 22 is capable of supplying oxygen to the semiconductor layer 30. The second insulating layer 22 is capable of suppressing the penetration of hydrogen into the semiconductor layer 30. Thereby, good switching characteristics can be maintained even in the case where, for example, the state occurs in which good switching characteristics of the thin film transistor 110 would degrade due to a decrease of the oxygen concentration of the semiconductor layer 30.

The semiconductor layer 30 is provided in contact with the second insulating layer 22 of a compound including oxygen. The interface between the semiconductor layer 30 and the second insulating layer 22 is a high-quality interface formed between layers of ionic oxides. Thereby, better characteristics of the semiconductor layer 30 are obtained.

The third insulating layer 23 may include, for example, silicon oxide (e.g., SiO₂, i.e., SiOₓ), etc. The third insulating layer 23 is capable of supplying oxygen to the semiconductor layer 30. Thereby, oxygen can be supplied to the semiconductor layer 30 also from the third insulating layer 23; and good switching characteristics can be maintained.

Also, in the embodiment, the second insulating layer 22 functions as a stopper when patterning the semiconductor layer 30. Thereby, a practical process window is obtained when forming the thin film transistor 110 that uses the semiconductor layer 30 of the oxide.

According to the embodiment, a practical semiconductor device having high integration can be provided.

Further downsizing can be realized by forming an amplifier for the functional element 155, which is an imaging element, etc., and a transistor for controlling the functional element 155 in a layer on the functional element 155. A thin film transistor may be used as the transistor provided in the layer on the functional element 155. It is favorable for the semiconductor layer of the thin film transistor to be a semiconductor material that can be formed at a temperature that is lower than that of a CMOS process. An oxide semiconductor may be used as the semiconductor layer.

The oxide semiconductor can be formed uniformly as a film over a large surface area at room temperature by, for example, sputtering; and a relatively low process temperature of 300 °C to 400 °C is applicable. Further, a relatively high field effect mobility is obtained in the oxide semiconductor.

The inventor of the application discovered that there are cases where it is difficult to obtain the desired characteristics of the thin film transistor using such an oxide semiconductor.

For example, in the case where a silicon nitride layer (the first insulating layer 21), which is usable as the etching stopper film of an inter-layer insulating film, is used as the gate insulating film of the thin film transistor 110, over-etching of the silicon nitride layer occurs when patterning the semiconductor layer 30; and it is difficult to form the desired configuration. This is because the etching selectivity between the semiconductor layer 30 and the silicon nitride layer is low. In the case where over-etching of the silicon nitride layer occurs, defects such as leaks, etc., occur; and a thin film transistor having good characteristics is not obtained.

On the other hand, in the case where a layer of a metal oxide (e.g., Al₂O₃, etc.) is used as the gate insulating film of the thin film transistor 110, sufficient selectivity is obtained when patterning the semiconductor layer 30; and the semiconductor layer 30 can be patterned substantially without damaging the layer of the metal oxide. However, the metal oxide has poor blocking properties for the first gate electrode 11 formed in the foundation insulating layer 160. Therefore, for example, it is easy for the metallic elements, etc. (e.g., Cu, etc.) included in the first gate electrode 11 to move through the layer of the metal oxide into the semiconductor layer 30. Thereby, there are cases where the characteristics of the semiconductor layer 30 degrade.

Conversely, in the embodiment, the foundation insulating layer 160 and the first gate electrode 11 are covered with the first insulating layer 21 that includes nitrogen and has good blocking properties. The first insulating layer 21 is covered with the second insulating layer 22 that has high selectivity with the semiconductor layer 30.

Thereby, good patterning of the semiconductor layer 30 can be realized; and simultaneously, the movement of the metal, etc., from the lower layer can be blocked. Also, the second insulating layer 22 can suppress the movement of hydrogen from the first insulating layer 21 toward the semiconductor layer 30.

In the embodiment, the first insulating layer 21 may include, for example, silicon nitride or silicon oxynitride. The second insulating layer 22 may include a metal compound including oxygen.

In the case where silicon oxynitride is used as the first insulating layer 21 and silicon oxynitride is used as the second insulating layer 22, the oxygen concentration of the first insulating layer 21 is lower than the oxygen concentration of the second insulating layer 22. Thereby, good blocking properties of the first insulating layer 21 can be ensured. Also, good oxygen-supplying properties of the second insulating layer 22 toward the semiconductor layer 30 can be ensured. Further, the second insulating layer 22 can suppress the penetration of hydrogen into the semiconductor layer 30.

In other words, the diffusion of hydrogen from the first insulating layer 21 toward the semiconductor layer 30 can be suppressed by using the stacked structure of the first insulating layer 21 and the second insulating layer 22. Thereby, good characteristics of the semiconductor layer 30 can be maintained.

In the embodiment, the second insulating layer 22 functions as a portion of the gate insulating film. Therefore, it is favorable for the relative dielectric constant of the second insulating layer 22 to be high. A high relative dielectric constant is obtained by using the first compound that includes oxygen and at least one selected from Al, Ti, Ta, Hf, and Zr as the second insulating layer 22. Thereby, the driving capacity of the thin film transistor 110 improves.

On the other hand, it is not always necessary for the third insulating layer 23 that covers the upper surface (and the side surface 30s) of the semiconductor layer 30 to include a material having a high relative dielectric constant. The third insulating layer 23 may include, for example, an appropriate material that includes oxygen (e.g., SiO2, etc.) by considering the patternability, the reliability, etc. Good characteristics of the semiconductor layer 30 can be maintained by the third insulating layer 23 including an insulating material including oxygen.

According to the embodiment, a practical thin film transistor having high mobility and high reliability is obtained.

For example, an imaging element or the like is applied to the functional element 155 of the substrate 150 of the semiconductor device 210. A CMOS image sensor (imaging element) using a CMOS process may be used as the functional element 155. In the imaging element, for example, the light reception surface area of the photodiode decreases and the S/N ratio degrades as downscaling progresses. In the embodiment, by forming the amplifier for the imaging element and the transistor for controlling the imaging element in an interconnect layer on the photodiode, both the downscaling and the S/N ratio can be ensured.

The thickness of the first insulating layer 21 is, for example, not less than 5 nanometers (nm) and not more than 50 nm.

The thickness of the second insulating layer 22 is, for example, not more than 50 nm. It is favorable for the thickness of the second insulating layer 22 to be not less than 10 nm. It is easy for the second insulating layer 22 to function as an etching stopper when the thickness of the second insulating layer 22 is not less than 100 nm. For example, the stopper function degrades when the second insulating layer 22 is too thin.

In the embodiment, at least one selected from the first gate electrode 11, the first conductive layer 41, and the second conductive layer 42 may include at least one selected from aluminum, copper, tungsten, tantalum, molybdenum, and titanium.

In the example, the first gate electrode 11 includes a first layer 11a for the first gate electrode 11 and a second layer 11b for the first gate electrode 11. The second layer 11b is stacked with the first layer 11a. The second layer 11b is disposed between the first layer 11a and the foundation insulating layer 160. The first layer 11a includes at least one metal selected from aluminum, copper, tungsten, tantalum, molybdenum, and titanium. The second layer 11b may include a material that is different from that of the first layer 11a. The second layer 11b includes at least one selected from tantalum, tantalum nitride, and titanium nitride.

For example, the first gate electrode 11 may further include a third layer 11c for the first gate electrode 11. The third layer 11c is provided between the first layer 11a and the second layer 11b. For example, at least one metal selected from aluminum and copper may be used as the first layer 11a. Tantalum nitride may be used as the second layer 11b. Tantalum may be used as the third layer 11c.

In the example, the first conductive layer 41 includes a first layer 41a for the first conductive layer 41 and a second layer 41b for the first conductive layer 41. The second layer 41b is stacked with the first layer 41a. The second layer 41b is disposed between the first layer 41a and the third insulating layer 23. The first layer 41a includes at least one metal selected from aluminum, copper, tungsten, tantalum, molybdenum, and titanium. The second layer 41b may include a material that is different from that of the first layer 41a. The second layer 41b includes at least one selected from tantalum, tantalum nitride, and titanium nitride.

For example, the first conductive layer 41 may further include a third layer 41c for the first conductive layer 41. The third layer 41c is provided between the first layer 41a and the second layer 41b. For example, at least one metal selected from aluminum and copper may be used as the first layer 41a. Tantalum nitride may be used as the second layer 41b. Tantalum may be used as the third layer 41c.

In the example, the second conductive layer 42 includes a first layer 42a for the second conductive layer 42 and a second layer 42b for the second conductive layer 42. The second layer 42b is stacked with the first layer 42a. The second layer 42b is disposed between the first layer 42a and the third insulating layer 23. The first layer 42a includes at least one metal selected from aluminum, copper, tungsten, tantalum, molybdenum, and titanium. The second layer 42b may include a material that is different from that of the first layer 42a. The second layer 42b includes at least one selected from tantalum, tantalum nitride, and titanium nitride.

For example, the second conductive layer 42 may further include a third layer 42c for the second conductive layer 42. The third layer 42c is provided between the first layer 42a and the second layer 42b. For example, at least one metal selected from aluminum and copper may be used as the first layer 42a. Tantalum nitride may be used as the second layer 42b. Tantalum may be used as the third layer 42c.

FIG. 4 is a schematic cross-sectional view showing a portion of another semiconductor device according to the first embodiment. FIG. 4 shows a thin film transistor 111 included in the semiconductor device 211 according to the embodiment.

In the thin film transistor 111 of the semiconductor device 211 as shown in FIG. 4, the second insulating layer 22 further has a portion 22p provided on the sixth portion p6 of the semiconductor layer 30. The second insulating layer 22 covers, for example, the semiconductor layer 30 except for the fourth portion p4 and the fifth portion p5. For example, the second insulating layer 22 covers the side surface 30s of the semiconductor layer 30. The third insulating layer 23 covers the semiconductor layer 30 with the second insulating layer 22 interposed. Otherwise, the thin film transistor 111 may be similar to the thin film transistor 110; and a description is therefore omitted.

In the semiconductor device 211 as well, a practical semiconductor device having high integration can be provided. In the semiconductor device 211, the second insulating layer 22 covers not only the lower surface of the semiconductor layer 30 but also the upper surface and the side surface 30s of the semiconductor layer 30. By covering the semiconductor layer 30 with the same material, more stable characteristics of the thin film transistor 111 are obtained.

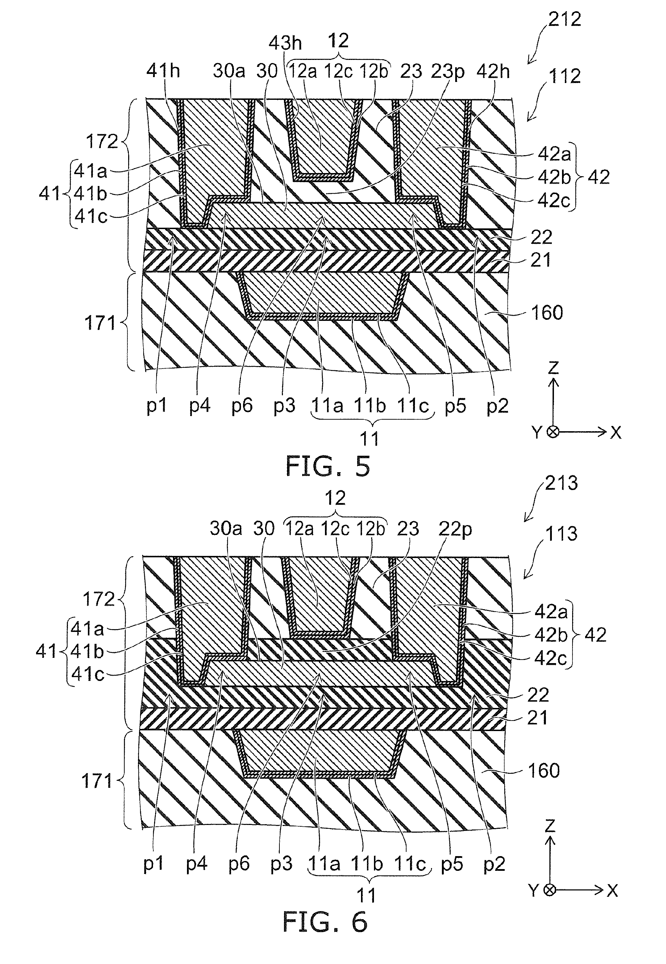

FIG. 5 is a schematic cross-sectional view showing a portion of another semiconductor device according to the first embodiment. FIG. 5 shows a thin film transistor 112 included in the semiconductor device 212 according to the embodiment.

As shown in FIG. 5, the thin film transistor 112 of the semiconductor device 212 has a double-gate structure. Namely, the thin film transistor 112 further includes a second gate electrode 12. Otherwise, the thin film transistor 112 may be similar to the thin film transistor 110; and a description is therefore omitted. In the semiconductor device 212, a portion of the interconnect of the first interconnect layer 171 may be used as the first gate electrode 11 of the thin film transistor 112; and a portion of the interconnect of the second interconnect layer 172 may be used as the second gate electrode 12.

The second gate electrode 12 is provided on the sixth portion p6 of the semiconductor layer 30. The third insulating layer 23 has a portion 23p provided between the sixth portion p6 and the second gate electrode 12. The second gate electrode 12 is formed by, for example, filling a conductive material into a third hole 43h provided in the third insulating layer 23. The third hole 43h is provided between the first hole 41h and the second hole 42h.

Because the thin film transistor 112 has a double-gate structure, more stable characteristics are obtained. In the semiconductor device 212 as well, a practical semiconductor device having high integration can be provided.

The second gate electrode 12 may include at least one selected from aluminum, copper, tungsten, tantalum, molybdenum, and titanium.

In the example, the second gate electrode 12 includes a first layer 12a for the second gate electrode 12 and a second layer 12b for the second gate electrode 12. The second layer 12b is stacked with the first layer 12a. The second layer 12b is disposed between the first layer 12a and the third insulating layer 23. The first layer 12a includes at least one metal selected from aluminum, copper, tungsten, tantalum, molybdenum, and titanium. The second layer 12b may include a material that is different from that of the first layer 12a. The second layer 12b includes at least one selected from tantalum, tantalum nitride, and titanium nitride.

For example, the second gate electrode 12 may further include a third layer 12c for the second gate electrode 12. The third layer 12c is provided between the first layer 12a and the second layer 12b. For example, at least one metal selected from aluminum and copper may be used as the first layer 12a. Tantalum nitride may be used as the second layer 12b. Tantalum may be used as the third layer 12c.

In the case where the second gate electrode 12 is provided, the interconnect 50 (referring to FIG. 1) may be connected to the second gate electrode 12. In other words, the semiconductor device 212 may further include, for example, the interconnect 50 for the second gate electrode that pierces the foundation insulating layer 160 and at least a portion of the third insulating layer 23 along the Z-axis direction (e.g., the direction intersecting the upper surface 150a of the substrate 150). The interconnect 50 electrically connects, for example, the functional element 155 to the second gate electrode 12.

FIG. 6 is a schematic cross-sectional view showing a portion of another semiconductor device according to the first embodiment. FIG. 6 shows a thin film transistor 113 included in the semiconductor device 213 according to the embodiment.

In the thin film transistor 113 of the semiconductor device 213 as shown in FIG. 6, the second insulating layer 22 further has the portion 22p provided on the sixth portion p6 of the semiconductor layer 30. In other words, the second insulating layer 22 has the portion 22p provided between the sixth portion p6 and the second gate electrode 12. Otherwise, the thin film transistor 113 may be similar to the thin film transistor 112; and a description is therefore omitted.

The second insulating layer 22 covers, for example, the semiconductor layer 30 except for the fourth portion p4 and the fifth portion p5. For example, the second insulating layer 22 covers the side surface 30s of the semiconductor layer 30. The third insulating layer 23 covers the semiconductor layer 30 with the second insulating layer 22 interposed.

In the semiconductor device 213 as well, a practical semiconductor device having high integration can be provided. In the semiconductor device 213, the second insulating layer 22 covers not only the lower surface of the semiconductor layer 30 but also the upper surface and the side surface 30s of the semiconductor layer 30. The semiconductor layer 30 is covered with the same material. Further, a double-gate structure is applied. More stable characteristics of the thin film transistor 113 are obtained.

### Second embodiment

In the embodiment, a thin film transistor having a top-gate structure is provided.

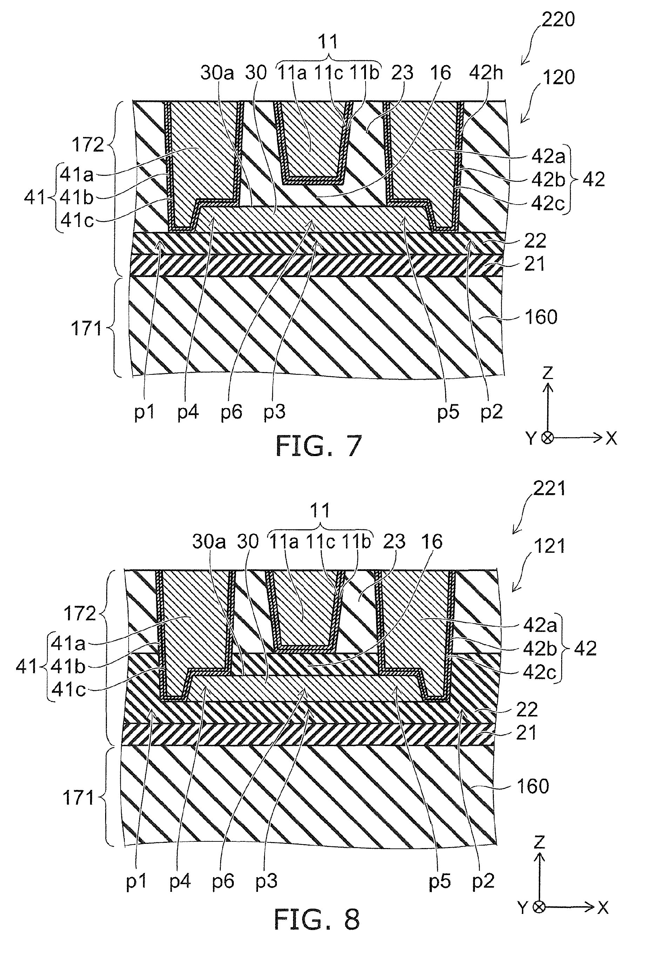

FIG. 7 is a schematic cross-sectional view showing a portion of a semiconductor device according to the second embodiment.

FIG. 7 shows the thin film transistor 120 included in the semiconductor device 220 according to the embodiment.

The substrate 150 described in regard to FIG. 1 also is provided in the semiconductor device 220. In such a case as well, the substrate 150 includes the functional element 155 and has the upper surface 150a. In the semiconductor device 220 as well, the foundation insulating layer 160 is provided on the upper surface 150a. Also, the interconnect 50 may be provided. The substrate 150, the foundation insulating layer 160, and the interconnect 50 may be similar to those of the semiconductor device 210; and a description is therefore omitted. In the semiconductor device 220, a portion of the interconnect of the second interconnect layer 172 may be used as the first gate electrode 11 of the thin film transistor 120. The portion positioned on the foundation insulating layer 160 will now be described.

The semiconductor device 220 includes the first insulating layer 21, the second insulating layer 22, the semiconductor layer 30, a gate insulation layer 16, the first gate electrode 11, the first conductive layer 41, the second conductive layer 42, and the third insulating layer 23 in addition to the substrate 150, the foundation insulating layer 160, and the interconnect 50. The semiconductor layer 30, the gate insulation layer 16, the first gate electrode 11, the first conductive layer 41, the second conductive layer 42, and the third insulating layer 23 are included, for example, in the thin film transistor 120.

The first insulating layer 21 is provided on the foundation insulating layer 160. The first insulating layer 21 includes silicon and nitrogen. The first insulating layer 21 may include, for example, silicon nitride or silicon oxynitride.

The second insulating layer 22 is provided on the first insulating layer 21. The second insulating layer 22 has the first portion p1, the second portion p2, and the third portion p3. The second portion p2 is separated from the first portion p1 in the first direction (e.g., the X-axis direction) in the X-Y plane (the plane parallel to the upper surface 150a). The third portion p3 is provided between the first portion p1 and the second portion p2. In such a case as well, the second insulating layer 22 includes oxygen and at least one selected from Al, Ti, Ta, Hf, and Zr.

The semiconductor layer 30 contacts the second insulating layer 22 on the third portion p3. The semiconductor layer 30 has the fourth portion p4, the fifth portion p5, and the sixth portion p6. The fifth portion p5 is separated from the fourth portion p4 in the first direction (the X-axis direction). The sixth portion p6 is provided between the fourth portion p4 and the fifth portion p5. The semiconductor layer 30 may include an oxide including at least one selected from indium, gallium, and zinc.

In such a case as well, the fourth portion p4 is disposed between the sixth portion p6 and the first portion p1 when projected onto the X-Y plane. The fifth portion p5 is disposed between the sixth portion p6 and the second portion p2 when projected onto the X-Y plane. The sixth portion p6 overlaps the third portion p3 when projected onto the X-Y plane.

The gate insulation layer 16 is provided on the sixth portion p6 of the semiconductor layer 30. The gate insulation layer 16 includes a metal and oxygen. The gate insulation layer 16 may include, for example, oxygen and at least one selected from Al, Ti, Ta, Hf, and Zr.

The first gate electrode 11 is provided on the gate insulation layer 16. In other words, the gate insulation layer 16 is provided between the first gate electrode 11 and the sixth portion p6 of the semiconductor layer 30.

The first conductive layer 41 contacts the first portion p1 and the fourth portion p4. The second conductive layer 42 contacts the second portion p2 and the fifth portion p5.

The third insulating layer 23 covers a portion of the semiconductor layer 30 other than the fourth portion p4 and the fifth portion p5. The third insulating layer 23 may be continuous with the gate insulation layer 16. The third insulating layer 23 may cover the sixth portion p6 of the semiconductor layer 30 with the gate insulation layer 16 interposed. The third insulating layer 23 may also cover the side surface 30s of the semiconductor layer 30. The third insulating layer 23 includes oxygen and at least one selected from Si, Al, Ti, Ta, Hf, and Zr.

In the embodiment as well, the foundation insulating layer 160 and the first gate electrode 11 are covered with the first insulating layer 21 that includes nitrogen and has high blocking properties. Further, the first insulating layer 21 is covered with the second insulating layer 22 that has high selectivity with the semiconductor layer 30. Thereby, good patterning of the semiconductor layer 30 can be realized; and simultaneously, the movement of the metal, etc., from the lower layer can be blocked. Further, the second insulating layer 22 can suppress the movement of hydrogen from the first insulating layer 21 toward the semiconductor layer 30. Moreover, good oxygen-supplying properties of the second insulating layer 22 toward the semiconductor layer 30 can be ensured. Thereby, good characteristics of the semiconductor layer 30 can be maintained.

In the embodiment, it is favorable for the relative dielectric constant of the gate insulation layer 16 to be high. A high relative dielectric constant is obtained by using a compound including oxygen and at least one selected from Al, Ti, Ta, Hf, and Zr as the gate insulation layer 16. Thereby, the driving capacity of the thin film transistor 120 improves.

According to the embodiment, a practical thin film transistor having high mobility and high reliability is obtained. In the embodiment as well, a practical semiconductor device having high integration can be provided.

In the example, the material of the third insulating layer 23 may be the same as the material of the gate insulation layer 16. In such a case, the third insulating layer 23 is continuous with the gate insulation layer 16; and a boundary is not observed. The portion of the insulating layer made of this material positioned between the semiconductor layer 30 and the first gate electrode 11 is used as the gate insulation layer 16. The other portions are used as the third insulating layer 23.

FIG. 8 is a schematic cross-sectional view showing a portion of another semiconductor device according to the second embodiment. FIG. 8 shows a thin film transistor 121 included in the semiconductor device 221 according to the embodiment.

In the thin film transistor 121 as shown in FIG. 8, the gate insulation layer 16 is continuous with the second insulating layer 22. For example, the material of the gate insulation layer 16 is the same as the material of the second insulating layer 22. For example, the gate insulation layer 16 and the second insulating layer 22 may include a compound including oxygen and at least one selected from Al, Ti, Ta, Hf, and Zr. A high relative dielectric constant and good etching stopper properties are obtained.

Because the lower surface and upper surface of the semiconductor layer 30 are covered with the same material, more stable characteristics of the thin film transistor 121 are obtained. In the semiconductor device 211 as well, a practical semiconductor device having high integration can be provided.

### Third embodiment

The embodiment relates to a method for manufacturing the semiconductor device according to the first embodiment.

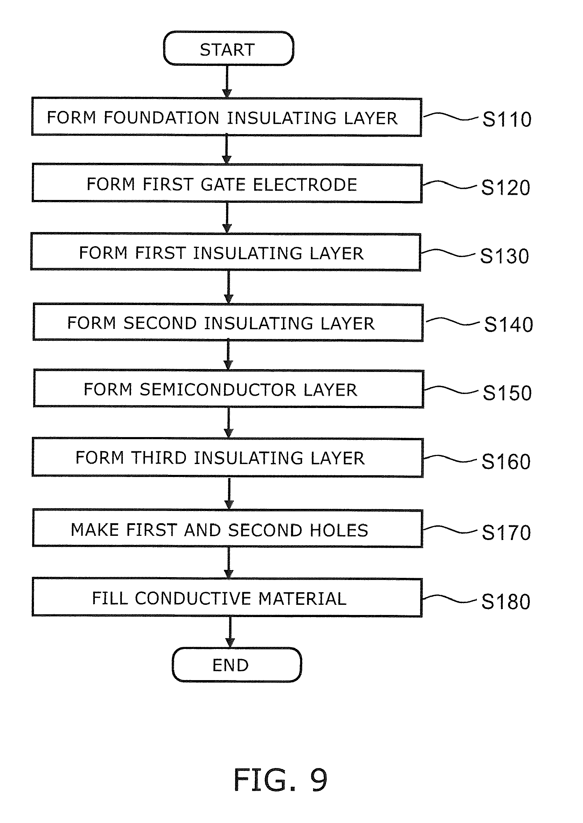

FIG. 9 is a flowchart showing the method for manufacturing the semiconductor device according to the third embodiment.

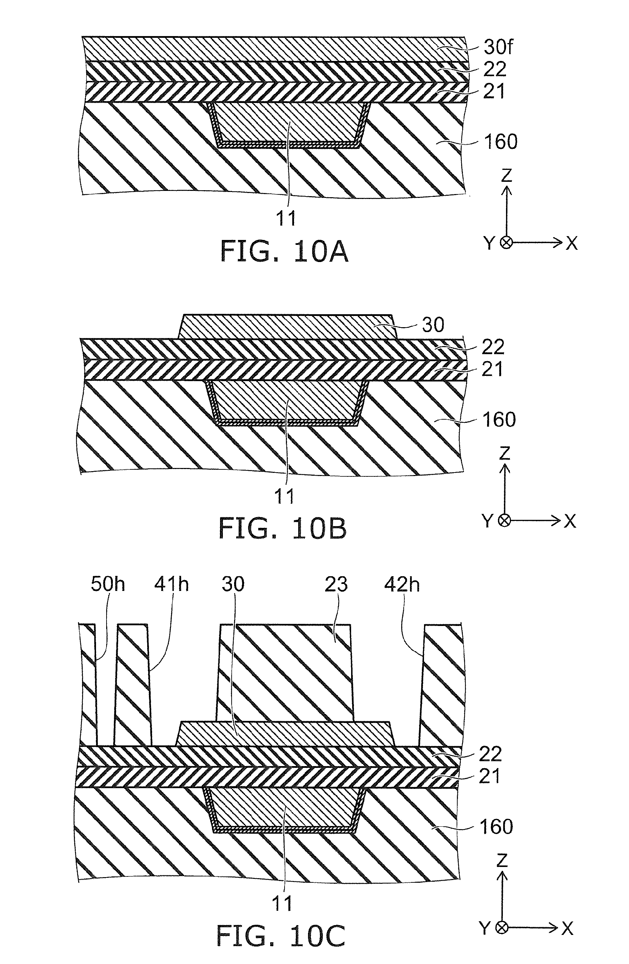

FIG. 10A to FIG. 10C are schematic cross-sectional views in order of the processes, showing the method for manufacturing the semiconductor device according to the third embodiment.

In the manufacturing method as shown in FIG. 9, the foundation insulating layer 160 is formed on the upper surface 150a of the substrate 150 that includes the functional element 155 (step S110).

The first gate electrode 11 is formed on a portion of the foundation insulating layer 160 (step S120).

The first insulating layer 21 that includes silicon and nitrogen is formed to cover the first gate electrode 11 and the foundation insulating layer 160 (step S130).

The second insulating layer 22 including oxygen and at least one selected from Al, Ti, Ta, Hf, and Zr is formed on the first insulating layer 21 (step S140).

As shown in FIG. 10A, a semiconductor film 30f of an oxide including at least one selected from indium, gallium, and zinc is formed on the second insulating layer 22.

As shown in FIG. 10B, the semiconductor layer 30 is formed from the semiconductor film 30f by patterning the semiconductor film 30f using the second insulating layer 22 as a stopper (step S150). For example, dry etching is used to pattern the semiconductor film 30f. For example, a gas including chlorine is used in the dry etching. A gas including boron trichloride may be used.

The third insulating layer 23 that includes oxygen and at least one selected from Si, Al, Ti, Ta, Hf, and Zr is formed on the semiconductor layer 30 and on the second insulating layer 22 (step S160).

As shown in FIG. 10C, the first hole 41h is made from the upper surface of the third insulating layer 23 to reach the semiconductor layer 30; and the second hole 42h is made from the upper surface of the third insulating layer 23 to reach the semiconductor layer 30 and is separated from the first hole 41h (step S170). When making the first hole 41h and the second hole 42h, for example, the second insulating layer 22 may be used as a stopper. For example, dry etching is used to make the first hole 41h and the second hole 42h. In the dry etching, for example, a gas including at least one selected from tetrafluoromethane, trifluoromethane, and oxygen is used.

A conductive material is filled into the first hole 41h and the second hole 42h (step S180). The first conductive layer 41 is formed of the conductive material that is filled into the first hole 41h. The second conductive layer 42 is formed of the conductive material that is filled into the second hole 42h. Thus, a thin film transistor (e.g., the thin film transistor 110) including the semiconductor layer 30 is formed.

The making of the first hole 41h and the second hole 42h recited above (step S170) may include making the third hole 43h from the upper surface of the third insulating layer 23 to be separated from the semiconductor layer 30. The third hole 43h is made between the first hole 41h and the second hole 42h. The filling of the conductive material (step S180) may include filling the conductive material into the third hole 43h. Thereby, the second gate electrode 12 can be formed.

According to the manufacturing method according to the embodiment, a method for manufacturing a practical semiconductor device having high integration can be provided.

In the embodiment as shown in FIG. 10C, a hole (an interconnect hole 50h) for the interconnect 50 may be further provided. In other words, the making of the first hole 41h and the second hole 42h (step S170) may include making the interconnect hole 50h in which at least a portion of the interconnect 50 that electrically connects the functional element 155 to the thin film transistor is formed. The filling of the conductive material (step S180) may include filling the conductive material into the interconnect hole 50h. Thereby, at least a portion of the interconnect 50 can be formed.

### Fourth embodiment

The embodiment relates to a method for manufacturing the semiconductor device according to the second embodiment.

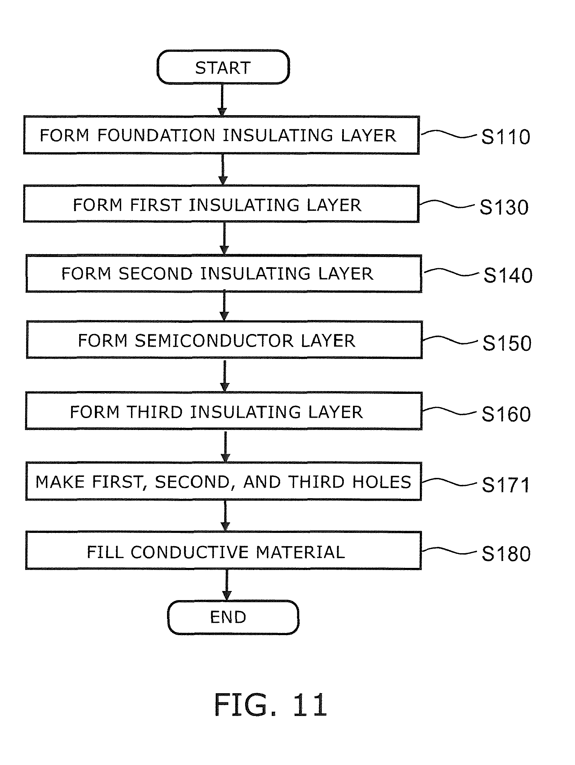

FIG. 11 is a flowchart showing the method for manufacturing the semiconductor device according to the fourth embodiment.

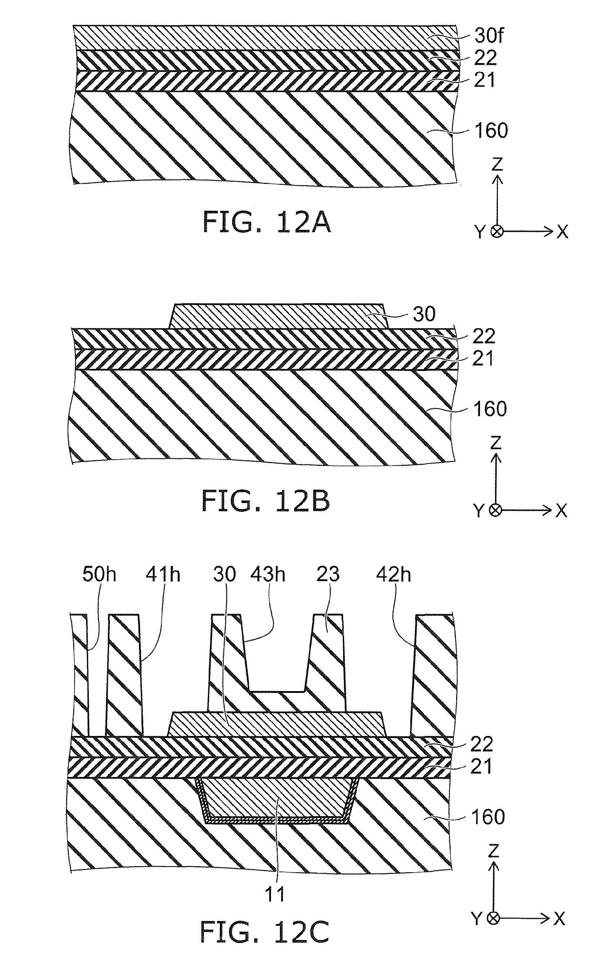

FIG. 12A to FIG. 12C are schematic cross-sectional views in order of the processes, showing the method for manufacturing the semiconductor device according to the fourth embodiment.

In the manufacturing method as shown in FIG. 11, the foundation insulating layer 160 is formed on the upper surface 150a of the substrate 150 that includes the functional element 155 (step S110).

The first insulating layer 21 that includes silicon and nitrogen is formed on the foundation insulating layer 160 (step S130).

The second insulating layer 22 including oxygen and at least one selected from Al, Ti, Ta, Hf, and Zr is formed on the first insulating layer 21 (step S140).

As shown in FIG. 12A, the semiconductor film 30f of an oxide including at least one selected from indium, gallium, and zinc is formed on the second insulating layer 22.

As shown in FIG. 12B, the semiconductor layer 30 is formed from the semiconductor film 30f by patterning the semiconductor film 30f using the second insulating layer 22 as a stopper (step S150). In such a case as well, for example, dry etching is used to pattern the semiconductor film 30f. For example, a gas including chlorine is used in the dry etching. A gas including boron trichloride may be used.

The third insulating layer 23 that includes oxygen and at least one selected from Si, Al, Ti, Ta, Hf, and Zr is formed on the semiconductor layer 30 and on the second insulating layer 22 (step S160). For example, the portion of the third insulating layer 23 on the semiconductor layer 30 is used as the gate insulation layer 16.

As shown in FIG. 12C, the first hole 41h is made from the upper surface of the third insulating layer 23 to reach the semiconductor layer 30; the second hole 42h is made from the upper surface of the third insulating layer 23 to reach the semiconductor layer 30 and is separated from the first hole 41h; and the third hole 43h is made from the upper surface of the third insulating layer 23 between the first hole 41h and the second hole 42h to be separated from the semiconductor layer 30 (step S171). For example, dry etching is used to make the first hole 41h, the second hole 42h, and the third hole 43h. In such a case as well, for example, a gas including at least one selected from tetrafluoromethane, trifluoromethane, and oxygen is used in the dry etching.

A conductive material is filled into the first hole 41h, the second hole 42h, and the third hole 43h (step S180). The first conductive layer 41 is formed of the conductive material that is filled into the first hole 41h. The second conductive layer 42 is formed of the conductive material that is filled into the second hole 42h. The first gate electrode 11 is formed of the conductive material that is filled into the third hole 43h. Thus, a thin film transistor (e.g., the thin film transistor 120) including the semiconductor layer 30 is formed.

According to the manufacturing method according to the embodiment, a method for manufacturing a practical semiconductor device having high integration can be provided.

In such a case as well, as shown in FIG. 12C, the making of the first hole 41h and the second hole 42h (step S171) may include making the interconnect hole 50h in which at least a portion of the interconnect 50 that electrically connects the functional element 155 to the thin film transistor is formed. Then, the filling of the conductive material (step S180) may include filling the conductive material into the interconnect hole 50h. Thereby, at least a portion of the interconnect 50 can be formed.

In the first to fourth embodiments, in the case where silicon oxide is used as the second insulating layer 22 and the third insulating layer 23, a TEOS film may be used as at least one selected from these layers. A porous film may be used as at least one selected from the second insulating layer 22 and the third insulating layer 23. The porous film may include, for example, SiOC. By using the porous film, for example, the parasitic capacitance between the interconnects can be reduced.

According to the embodiments, a practical semiconductor device having high integration and a method for manufacturing the semiconductor device can be provided.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, embodiments of the invention are described with reference to specific examples. However, the invention is not limited to these specific examples. For example, one skilled in the art may similarly practice the invention by appropriately selecting specific configurations of components included in the semiconductor device such as the substrate, the functional element, the foundation insulating layer, the first gate electrode, the second gate electrode, the first to third insulating layers, the gate insulation layer, the first conductive layer, the second conductive layer, the interconnect, the first to third interconnects, the inter-layer insulating layer, etc., from known art; and such practice is within the scope of the invention to the extent that similar effects are obtained.

Further, any two or more components of the specific examples may be combined within the extent of technical feasibility and are included in the scope of the invention to the extent that the purport of the invention is included.

Moreover, all semiconductor devices and methods for manufacturing the same practicable by an appropriate design modification by one skilled in the art based on the semiconductor devices and the methods for manufacturing the same described above as embodiments of the invention also are within the scope of the invention to the extent that the spirit of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A semiconductor device (210-213), comprising:
a substrate (150) including a functional element (155), the substrate (150) having an upper surface (150a);
a foundation insulating layer (160) provided on the upper surface (150a); and
a thin film transistor (110-113) including
a first gate electrode (11) provided on a portion of the foundation insulating layer (160),
a first insulating layer (21) covering the first gate electrode (11) and the foundation insulating layer (160), the first insulating layer (21) including silicon and nitrogen,
a second insulating layer (22) provided on the first insulating layer (21), the second insulating layer (22) including oxygen and at least one selected from Al, Ti, Ta, Hf, and Zr, the second insulating layer (22) having a first portion (p1), a second portion (p2) separated from the first portion (p2) in a first direction in a plane parallel to the upper surface (150a), and a third portion (p3) positioned on the first gate electrode (11) to be provided between the first portion (p1) and the second portion (p2),
a semiconductor layer (30) of an oxide including at least one selected from In, Ga, and Zn, the semiconductor layer (30) contacting the second insulating layer (22) on the third portion (p3), the semiconductor layer (30) having a fourth portion (p4), a fifth portion (p5) separated from the fourth portion (p4) in the first direction, and a sixth portion (p6) provided between the fourth portion (p4) and the fifth portion (p5), the fourth portion (p4) being disposed between the sixth portion (p6) and the first portion (p1) when projected onto the plane parallel to the upper surface (150a), the fifth portion (p5) being disposed between the sixth portion (p6) and the second portion (p2) when projected onto the plane parallel to the upper surface (150a),
a first conductive layer (41) contacting the fourth portion (p4),
a second conductive layer (42) contacting the fifth portion (p5), and
a third insulating layer (23) covering a portion of the semiconductor layer other than the fourth portion and the fifth portion, third insulating layer (23) including oxygen and at least one selected from Si, Al, Ti, Ta, Hf, and Zr.

2. The device (212, 213) according to claim 1, wherein the thin film transistor (112, 113) further includes a second gate electrode (12) provided on the sixth portion (p6).

3. The device (212, 213) according to claim 2, wherein the third insulating layer (23) has a portion provided between the sixth portion (p6) and the second gate electrode (12).

4. The device (211, 213) according to claim 1, wherein the second insulating layer (22) has a portion (22p) provided on the sixth portion (p6).

5. The device (210-213) according to claim 1, wherein a thickness of the second insulating layer (22) is not more than 50 nm.

6. The device (210-213) according to one of claims 1-5, wherein at least one selected from the first gate electrode (11), the first conductive layer (41), and the second conductive layer (42) includes at least one selected from aluminum, copper, tungsten, tantalum, molybdenum, and titanium.

7. The device (210-213) according to one of claims 1-6, wherein
the first insulating layer (21) includes silicon nitride, and
the second insulating layer (22) includes aluminum oxide.

8. The device (210-213) according to one of claims 1-7, wherein the third insulating layer (23) includes silicon oxide.

9. The device (210-213) according to one of claims 1-8, wherein the functional element (155) includes an imaging unit (156) provided at a lower surface (150b) of the substrate (150).

10. The device (210-213) according to one of claims 1-9, wherein
the first conductive layer (41) further contacts the first portion (41), and
the second conductive layer (42) further contacts the second portion (p2).

11. The device (210-213) according to one of claims 1-10, wherein the second insulating layer (42) is capable of supplying oxygen to the semiconductor layer (30).

12. The device (210-213) according to claim 11, wherein the third insulating layer (23) is capable of supplying oxygen to the semiconductor layer (30).

13. The device (210-213) according to claim 12, wherein the second insulating layer (22) is capable of suppressing penetration of hydrogen into the semiconductor layer (30).

14. A semiconductor device (220, 221), comprising:
a substrate (150) including a functional element (155), the substrate (150) having an upper surface (150a);
a foundation insulating layer (160) provided on the upper surface (150a);
a first insulating layer (21) provided on the foundation insulating layer, the first insulating layer (21) including silicon and nitrogen;
a second insulating layer (22 provided on the first insulating layer (21), the second insulating layer (22) including oxygen and at least one selected from Al, Ti, Ta, Hf, and Zr, the second insulating layer (22) having a first portion (p1), a second portion (p2) separated from the first portion (p1) in a first direction in a plane parallel to the upper surface (150a), and a third portion (p5) provided between the first portion (p1) and the second portion (p2); and
a thin film transistor (120, 121) including
a semiconductor layer (30) of an oxide including at least one selected from indium, gallium, and zinc, the semiconductor layer (30) contacting the second insulating layer (22) on the third portion (p3), the semiconductor layer (30) having a fourth portion (p4), a fifth portion (p5) separated from the fourth portion (p4) in the first direction, and a sixth portion (p6) provided between the fourth portion (p4) and the fifth portion (p5), the fourth portion (p4) being disposed between the sixth portion (p6) and the first portion (p1), the fifth portion (p5) being disposed between the sixth portion (p6) and the second portion (p2),
a gate insulation layer (16) provided on the sixth portion (p6), the gate insulation layer (16) including metal and oxygen,
a first gate electrode (11) provided on the gate insulation layer (11),
a first conductive layer (41) contacting the fourth portion (p4),
a second conductive layer (42) contacting the fifth portion (p5), and
a third insulating layer (23) covering a portion of the semiconductor layer (30) other than the fourth portion (p4) and the fifth portion (p5), the third insulating layer (23) including oxygen and at least one selected from Si, Al, Ti, Ta, Hf, and Zr.

15. The device (120, 121) according to claim 14, wherein a thickness of the second insulating layer (22) is not more than 50 nm.

16. The device (120, 121) according to one of claims 14 and 15, wherein at least one selected from the first gate electrode (11), the first conductive layer (41), and the second conductive layer (42) includes at least one selected from aluminum, copper, tungsten, tantalum, molybdenum, and titanium.

17. The device (120, 121) according to one of claims 14-16, wherein
the first insulating layer (21) includes silicon nitride, and
the second insulating layer (22) includes aluminum oxide.

18. The device (120, 121) according to one of claims 14-17, wherein the third insulating layer (23) includes silicon oxide.

19. The device (120, 121) according to one of claims 14-18, wherein the functional element (155) includes an imaging unit (156) provided at a lower surface (150b) of the substrate (150).

20. A method for manufacturing a semiconductor device (210-213), comprising:
forming a foundation insulating layer (160) on an upper surface (150a) of a substrate (150) including a functional element (155);
forming a first gate electrode (11) on a portion of the foundation insulating layer (160);
forming a first insulating layer (21) including silicon and nitrogen to cover the first gate electrode (11) and the foundation insulating layer (160);
forming a second insulating layer (21) including oxygen and at least one selected from Al, Ti, Ta, Hf, and Zr on the first insulating layer (21);
forming a semiconductor film (30f) of an oxide including at least one selected from indium, gallium, and zinc on the second insulating layer (22) and forming a semiconductor layer (30) from the semiconductor film (30f) by patterning the semiconductor film (30f) using the second insulating layer (22) as a stopper;
forming a third insulating layer (23) including oxygen and at least one selected from Si, Al, Ti, Ta, Hf, and Zr on the semiconductor layer (30) and on the second insulating layer(23);
making a first hole (41a) from an upper surface of the third insulating layer (23) to reach the semiconductor layer (30) and making a second hole (42h) from the upper surface of the third insulating layer (23) to reach the semiconductor layer (30) and be separated from the first hole (41h); and
forming a thin film transistor (110-113) including the semiconductor layer (30) by filling a conductive material into the first hole (41h) and the second hole (42h).
